# EUROPEAN PATENT APPLICATION

(11) **EP 0 601 868 A1**
(43) Date of publication of application: **15.06.1994**
(21) Application number: 93309941.8
(22) Date of filing: 10.12.1993
(51) Int. Cl.: H01L 21/82, H01L 27/108

(54) **Semiconductor memory devices**

(30) Priority: 10.12.1992 KR 9223802; 24.03.1993 KR 934636
(71) Applicant: Samsung Electronics Co., Ltd., Suwon-city, Kyungki-do 441-370 (KR)
(72) Inventor: Choi, Young-jae, Yongin-gun, Kyungki-do (KR); Chung, Tae-young, Suwon-city, Kyungki-do (KR); Park, Jong-woo, Kangnam-gu, Seoul (KR); Kim, Young-pil, Suwon-city, Kyungki-do (KR)
(74) Representative: Stanley, David William

(57) **Abstract**

In a manufacturing method for a semiconductor memory device, wherein a capacitor having a double fin-shaped structure is provided, a storage electrode is formed by applying a thick planar material (31) which is capable of being wet-etched, between the double fins consisting of conductive layers (30,34). Accordingly, the problem of a photolithography process caused by poor step difference of a conventional fin structure can be solved. By removing the wet-etchable material (31) before pattern-etching the first conductive layer (30) the storage electrode surface is less likely to be damaged as compared to a RIE step. Further, the storage electrode may be formed by using a thin high temperature oxide film (41) whose etching rate is great. Thus, the cell's topography may be improved and damage to the storage electrode decreased.

## Description

The present invention relates to the manufacture of semiconductor memory devices.

As semiconductor memory devices become more integrated, the surface area occupied by each unit cell should be decreased. Generally, the effective area of a charge-storage capacitor in each unit cell of a dynamic random access memory (DRAM) device is decreased as the cell size is decreased, which results in decreasing the capacitance. In such a DRAM cell, the decrease of capacitance inevitably results in an increase of soft errors which are caused by the inflow of noise charges generated by alpha particles. Therefore, increasing the cell capacitance by expanding the effective area of a capacitor concurrently with the decrease in cell size has been a primary task in the high integration of semiconductor memory devices.

In order to satisfy this requirement, a stack capacitor cell (STC) structure has been used since the latter 1970's. The STC cell is structured generally such that a MOS transistor is formed within an active region of a semiconductor substrate, with a capacitor being connected through a buried contact to the source region of the MOS transistor, and the storage electrode of the capacitor is horizontally extended to the upper part of the transistor's gate electrode and centered on the buried contact, which thereby forms a cell having a stacked capacitor structure. This structure can increase the effective area of a capacitor formed between the abovementioned storage electrode and a plate electrode formed in correspondence to the storage electrode.

Referring to a manufacturing process of a general STC cell, first, a MOS transistor is formed in the active region of a semiconductor substrate, and then a high temperature oxide (HTO) film is formed so as to insulate the gate electrode of the MOS transistor, and then a buried contact is formed over the source region of the MOS transistor. Thereafter, polysilicon is deposited for forming a storage electrode, and is then patterned by a conventional photolithography process, thus forming the storage electrode of the capacitor. After that, a dielectric film and plate electrode are formed corresponding to the storage electrode, and a bit line is formed to complete the STC cell.

However, the absolute effective area of a storage electrode in the general STC cell is inevitably reduced in accordance with the cell size which is also continuously decreased due to the higher integration of semiconductor memory devices. Therefore, the above STC cell structure is not suitable in manufacturing a DRAM device whose integration is beyond some limit, say, 16Mb.

A high dielectric film, e.g. tantalum oxide (Ta2O5), can be used as another method to increase the capacitance of a memory cell capacitor. However, when tantalum oxide is used, the leakage current is increased as compared with when silicon oxide or silicon nitride is used.

A trench capacitor cell is proposed and applied as another method for increasing cell capacitance, wherein a trench is formed in a semiconductor substrate and a capacitor is formed inside the trench. However, in 16Mb trench DRAM devices, the isolation of adjacent capacitors without interference is very difficult to achieve.

A fin-structured capacitor has been proposed to increase cell capacitance by means of expanding the effective area of a capacitor. This structure has drawn great attention among many current studies, due to its relatively simple manufacturing process and because a large cell capacitance can be assured.

The fin-structured capacitor is a kind of stacked capacitor and provides a storage electrode consisting of multiple conductive layers and spaces separating each conductive layer. Since the top, bottom and side surfaces of each conductive layer can be used as the effective area of the capacitor, this structure is very advantageous to high integration.

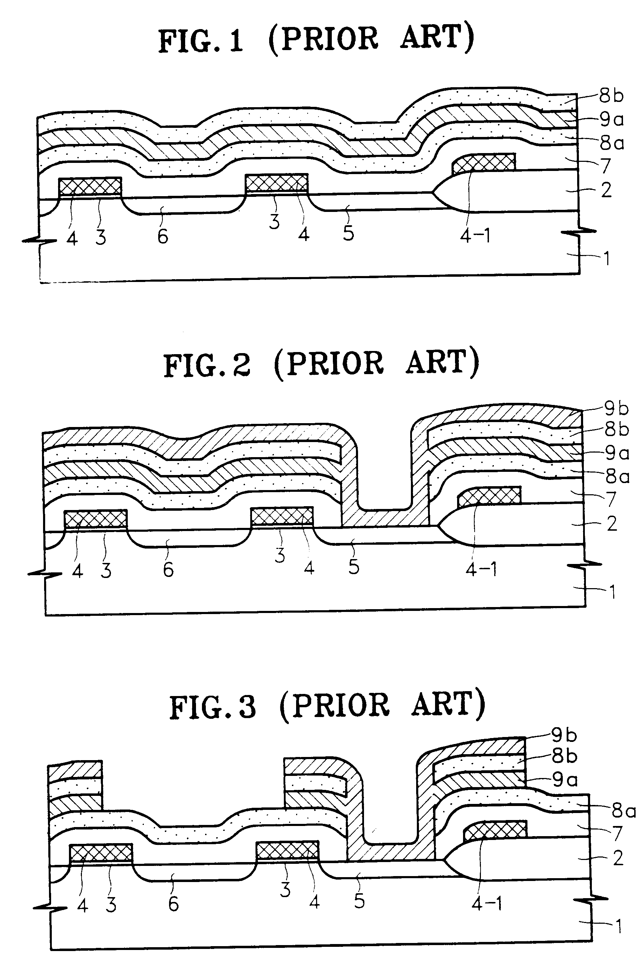

A conventional method for manufacturing such a fin-structured capacitor is explained as follows with reference to Figures 1 to Figure 5 of the accompanying diagrammatic drawings (see "3-Dimensional Stacked Capacitor Cell for 16M and 64M DRAMS" by T. Ema et al., IEDM '88, pp592-595).

Figure 1 is a sectional view showing a transistor formed in the active region of a semiconductor substrate, whereon alternating layers of insulating and conductive materials are deposited.

More particularly, a conventional LOCOS isolation method is performed on a semiconductor substrate 1 such that a non-active region composed of a field oxide film 2 can be distinguished from an active region defined by field oxide film 2. A MOS transistor comprised of a gate insulating film 3, a gate electrode 4. a source region 5 and a drain region 6 is formed in the active region, and a wordline 4-1 is formed on the field oxide film 2 by patterning simultaneously when the gate electrode 4 of the above transistor is patterned. Then, a nitride film 7 as an etching blocking layer is formed on the whole surface of the resultant structure in order to insulate gate electrode 4. Then, a first silicon oxide layer 8a, i.e. an insulating layer, and a first polysilicon layer 9a, i.e. a conductive layer, and a second silicon oxide layer 8b, i.e. an insulating layer, are successively formed on nitride film 7. At this time, for example, a two-tiered silicon oxide layer and a single polysilicon layer are formed alternately in a two-fin structure. (A three-tiered silicon oxide layer and two layers of polysilicon may be formed alternately in a three-fin structure.)

Figure 2 is a sectional view showing the formation of a conductive layer over the whole surface of the resultant structure, after a contact hole is formed on source region 5.

More particularly, a contact hole is formed on source region 5 by applying a mask pattern so as to connect the source region and a storage electrode of the capacitor. Then, a conductive layer, i.e. a second polysilicon layer 9b, is formed by depositing polysilicon on the whole surface of the semiconductor substrate including the contact hole, whereon first and second silicon oxide layers 8a and 8b and first polysilicon layer 9a have been sequentially formed.

Figure 3 is a sectional view showing the formation of a storage electrode pattern of the capacitor by patterning the resultant structure.

That is, an etching is sequentially performed by applying a mask pattern which leaves selective portions of the first and second polysilicon layer 9a and 9b and second oxide layer 8b within a certain range centering on the contact hole. Thus, the fin-structured storage electrode pattern having two polysilicon layers is formed.

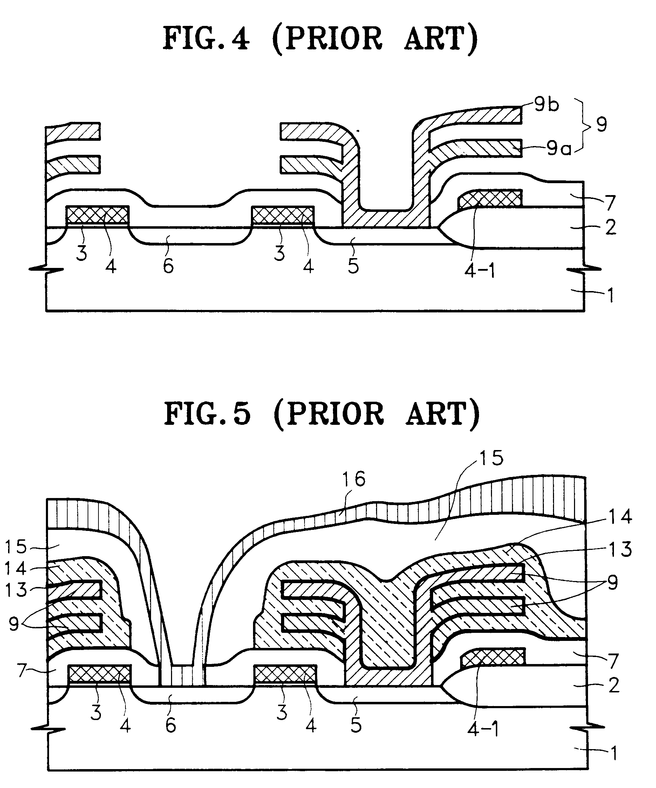

Figure 4 is a sectional view showing a completed storage electrode of the capacitor. That is, the second oxide layer 8b which remains between polysilicon layers 9a and 9b and the first oxide layer 8a formed on nitride film 7 are removed by wet-etching, and a fin-structured storage electrode 9 is thereby completed. At this time, nitride film 7 works as an anti-etching layer thereby to prevent the transistor from being damaged by the etching process.

Figure 5 is a sectional view showing a completed capacitor and a bit line. That is, a dielectric film 13 is formed on the upper surface of storage electrode 9, and then a polysilicon layer is deposited on the whole surface of the resultant, and then patterning is performed so as to form a plate electrode 14. Thereafter, an insulating film 15 is formed in order to insulate plate electrode 14 from a later-formed bit line. Bit line 16 is formed by depositing a conductive material on the whole surface of semiconductor substrate, after a contact hole is formed on drain region 6.

Since the above conventional fin-structured capacitor (disclosed by T. Ema) can improve its effective surface area as needed, sufficient cell capacitance can be assured, but the following problems still exist.

First, the etching process for forming a storage electrode pattern is performed by etching a polysilicon layer and silicon oxide layer alternately by means of a method of reactive ion etching. This method is overly complicated and damages the surface of the storage electrode due to changes in the etching process conditions for each layer, which results in the deterioration of the reliability of cell capacitance.

Second, a stringer is apt to be generated in a peripheral circuit region in which formation of a storage electrode should be avoided, when the silicon oxide layer and polysilicon layer are respectively etched in sequence, if the over-etch process for their removal is insufficient.

Third, since the conventional fin-structure forms a storage electrode which is vertically multi-layered, cell topography is very poor. Also, a photolithography margin for forming the contact hole and the storage electrode pattern is reduced.

Preferred embodiments of the present invention aim to provide a method of manufacturing a semiconductor device which can ensure a sufficient effective area of a capacitor and decrease the width of a buried contact, thereby to provide an improved process margin for forming a contact hole, and to enhance integration of a memory device.

It is another aim to provide a method of manufacturing a semiconductor device which can form a stable storage electrode by preventing the surface of a storage electrode of a capacitor from being damaged and preventing the storage electrode from being broken at its fin connections.

It is still another aim to provide a method of manufacturing a semiconductor device wherein improved cell topology is provided.

According to one aspect of the present invention, there is provided a method of manufacturing a semiconductor memory device comprising the steps of:
sequentially forming a first insulating layer and a first conductive layer on a semiconductor substrate on whose surface region is formed a transistor;
forming a planarized first material layer which can be wet-etched, on said first conductive layer;
forming a contact hole so as to expose said semiconductor substrate in a predetermined region of said first material layer;
forming a second conductive layer on said first material layer including said contact hole;
forming a photoresist pattern on said second conductive layer which ranges from the centre of said contact hole outwardly to a predetermined distance;
etching said second conductive layer formed below said photoresist pattern using said photoresist pattern as an etching mask;
wet-etching said first material layer below said second conductive layer; and
etching said first conductive layer formed below said first material layer using said photoresist pattern as an etching mask thereby to form a storage electrode of a capacitor consisting of the remainder of said first and second conductive layers.

Preferably, a gate electrode of said transistor is formed by forming a high temperature oxide film on a gate electrode forming material, and patterning said gate electrode forming material and high temperature oxide film together.

Preferably, the thickness of said high temperature oxide film is approximately 1,000Å or less.

Preferably, said first conductive layer is formed to a thickness of 500Å-3000Å using polysilicon.

Preferably, said first material layer is formed by depositing BPSG which then is flowed.

Preferably, said first material layer is wet-etched using HF or a BOE solution.

Preferably, a lower part of the contact hole is formed narrower than an upper part by performing a self-alignment process by means of said first conductive layer.

Preferably, the width of said contact hole is controlled by adjusting the thickness of said first conductive layer and the etching time.

A method as above may further comprise the step of baking said photoresist pattern after said first material layer is wet-etched away.

A method as above may further comprise the steps of removing the photoresist pattern which remains on said second conductive layer after forming said storage electrode of a capacitor; and forming a dielectric film and a plate electrode of the capacitor.

According to another aspect of the present invention, there is provided a method of manufacturing a semiconductor memory device comprising the steps of:
sequentially forming a first insulating layer and a first conductive layer on a semiconductor substrate on whose surface region is formed a transistor;
forming a second material layer having an etching rate greater than those of said first conductive layer and a subsequent second conductive layer to a substantially uniform thickness, on said first conductive layer;
forming a contact hole so as to expose said semiconductor substrate in a predetermined region of said second material layer;
forming said second conductive layer on said second material layer including said contact hole;
forming a photoresist pattern which ranges from the centre of said contact hole outwardly to a predetermined distance;
etching said second conductive layer formed below said photoresist pattern using said photoresist pattern as an etching mask;
wet-etching the second material layer below said second conductive layer; and
etching said first conductive layer formed below said second material layer using said photoresist pattern as an etching mask thereby to form a storage electrode of a capacitor consisting of the remainder of said first and second conductive layers.

Preferably, said second material layer is a high temperature oxide (HTO) film.

Preferably, the width of the contact hole is controlled by adjusting an amount of polymeric material generated when said HTO film is etched in forming the contact hole.

Preferably, said second conductive layer is formed such that the inside of said contact hole is not filled.

Preferably, said second material layer is wet-etched using HF or a BOE solution.

Preferably, the width of said contact hole is controlled by adjusting the thickness of said first conductive layer.

According to a further aspect of the present invention, there is provided a method of forming a capacitor of fin-structure as part of a semiconductor memory device, including the steps of forming first and second conductive layers which are spaced by a material that can be wet-etched, and subsequently wet-etching said material to remove it from between said first and second conductive layers.

A method as above may further comprise any one or more of the features disclosed in the accompanying specification, claims, abstract and/or drawings, in any combination.

The invention extends to a semiconductor memory device that has been manufactured by a method according to any of the preceding aspects of the invention.

In preferred embodiments of the invention, since the above-mentioned first or second material layer whose etching speed is greater than that of the above first conductive layer is formed on a first conductive layer, the first conductive layer remains in the shape of being protruded toward the inside of the contact hole because the first conductive layer operates as an etching block layer against the first or second material layer when the contact hole is formed in order to connect the storage electrode of capacitor to the source region of transistor.

Accordingly, the width of the contact hole can be reduced even when a conventional contact hole mask is used, and a mask having a larger exposing region can be used when the same-sized contact hole is formed.

Further, since the first and second material layers comprise a material capable of being wet-etched, the danger of stringer generation in the peripheral circuitry can be removed without over-etching and the risk damage to the storage electrode can be reduced.

For a better understanding of the invention, and to show how embodiments of the same may be carried into effect, reference will now be made, by way of example, to Figures 6 to 21 of the accompanying diagrammatic drawings, in which:

Figure 6 to Figure 15 are sectional views showing a method of manufacturing a DRAM cell according to a first embodiment of the present invention; and

Figure 16 to Figure 21 are sectional views showing a method of manufacturing a DRAM cell according to a second embodiment of the present invention.

In the figures, like reference numerals denote like or corresponding parts.

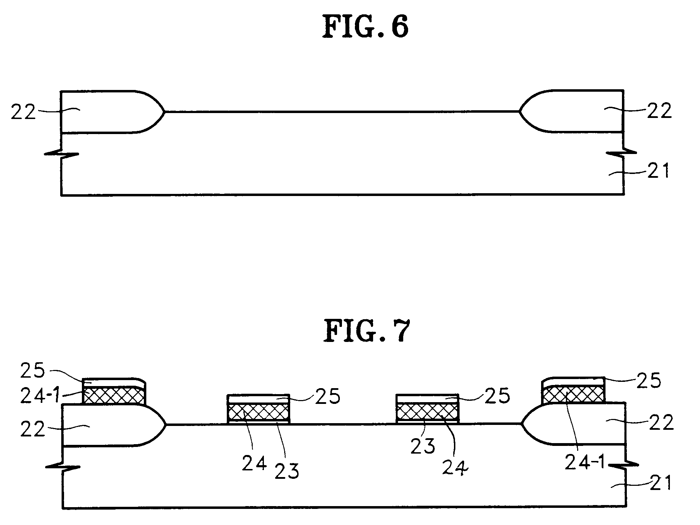

The first embodiment of the present invention will now be described with reference to Figures 6 to 15.

Figure 6 is a sectional view showing a step of forming a field oxide film 22 on a semiconductor substrate 21. That is, a non-active region, where a field oxide film 22 is formed on semiconductor substrate 21, and the element active region which is surrounded by the above field oxide film 22, are formed by applying a conventional isolation method such as a local oxidation of silicon (LOCOS).

Figure 7 is a sectional view showing a step of forming a gate electrode 24 on an active region of semiconductor substrate 21 and a word-line 24-1 on the non-active region thereof. More particularly, after gate insulating film 23 is formed on semiconductor substrate 21, a conductive layer (a gate electrode forming material layer) for gate electrode 24 is formed, whereon a high temperature oxide (HTO) for a first HTO film 25 is formed. Then, gate electrode 24 and wordline 24-1 are formed in the active region and non-active region, respectively, by simultaneously patterning the conductive layer via a conventional photolithography process. At this time, a first HTO film 25 formed on the gate electrode 24 may be formed to a thickness of 1,000Å∼3,000Å so as to prevent a short between the storage electrode within a contact hole and gate electrode 24 when an etching processing for forming a buried contact hole on the source region is performed. However, the forming step of first HTO film 25 may be omitted as necessary.

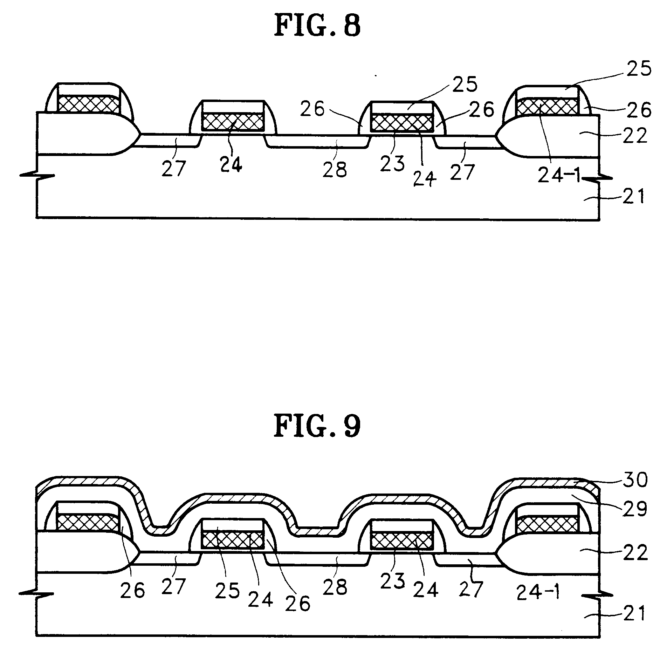

Figure 8 is a sectional view showing a step of forming the source/drain regions 27 and 28 of a transistor. Here, source region 27 and drain region 28 are formed by source/drain ion implantation, wherein the ion implantation to the gate electrode does not occur since a first HTO film 25 above gate electrode 24 or gate electrode 24 (when first HTO film is not formed) blocks the implantation thereof. Then, the HTO film is formed on the whole surface of the substrate, which is then etched and a second HTO spacer 26 is formed on the sidewalls of gate electrode 24 (and word line 24-1) and first HTO film 25.

Figure 9 is a sectional view showing a step of forming a third HTO film 29 over the entire resultant structure of Figure 8 for the insulation of the capacitor, whereon a first conductive layer 30 is formed so as to form a fin-shaped storage electrode of the capacitor.

First conductive layer 30 formed of a polysilicon not only serves to enlarge the capacitor's effective area but also acts as an etch-block film when the etching process is performed for the formation of a buried contact. First conductive layer 30 is formed thinly, for example, approximately 500Å to 3000Å, considering the topography of the entire cell, the enlarging the effective area and the contact hole size. It makes no difference if first conductive layer 30 is formed by ion-implanting arsenic to a polysilicon, by doping impurities using a POCl₃ deposition, or by using an impurity-doped polysilicon.

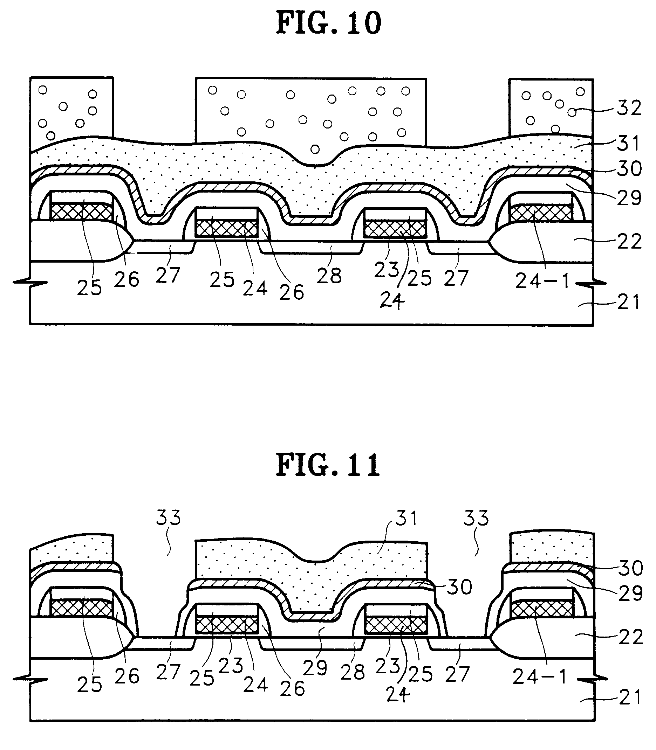

Figure 10 is a sectional view showing a step of forming a photoresist pattern 32 for forming a contact hole after a planarized first material layer 31 is formed on the first conductive layer 30. In order to form the planarized first material layer 31. a reflowable borophospho-silicate glass (BPSG) is deposited to a thickness of approximately 2,500Å to 4,000Å on top of first conductive layer 30, and then reflowed to planarize its surface. At this time, the temperature of the reflow-processing should be kept below 850°C so that the characteristics of the already formed transistors do not deteriorate. Here, by planarizing the substrate using BPSG film 31 before the buried contact is formed, a sufficient process margin can be assured for the photolithography processes to form the buried contact and the successively formed storage electrode. Then, a photoresist is coated on the planarized BPSG film 31, and a photolithography process is performed by applying a buried contact mask so as to form a photoresist pattern 32. At this time, the buried contact mask has a larger exposure area than that of a conventional buried contact mask used for manufacturing an STC cell. Using the buried contact mask having a large exposure area enables the contact hole to be easily opened when the buried contact photolithography processing is performed. Meanwhile, if a conventional buried contact mask is used as it is, the width of contact hole is reduced as compared to the conventional process, which gives advantage in the aspect of integration. Accordingly, the range of mask selection is enlarged.

Figure 11 is a sectional view showing a step of removing photoresist pattern 32 after the buried contact hole 33 is formed. More particularly, when BPSG film 31 exposed by photoresist pattern 32 is etched, first conductive layer 30 acts as an etching block layer for BPSG film 31, since the etching speed of the BPSG film 31 is greater than that of the first conductive layer 30. Then, the exposed first conductive layer 30 and third HTO film 29 are removed sequentially and then photoresist pattern 32 used for the buried contact pattern is removed, which completes the formation of the buried contact hole 33. Here. after etching, the exposed edge of first conductive layer 30 remains somewhat protruded beyond BPSG film 31 and toward the centre of the contact hole, due to the difference in the etching rates of the first conductive layer and BPSG film. The protrusion of first conductive layer 30 acts as an etching mask when third HTO film 29 is etched successively. Accordingly, the lower width of buried contact hole 33 is further narrowed, thereby preventing shorts between a second conductive layer which is subsequently filled in the buried contact hole 33 and gate electrode 24 or wordline 24-1.

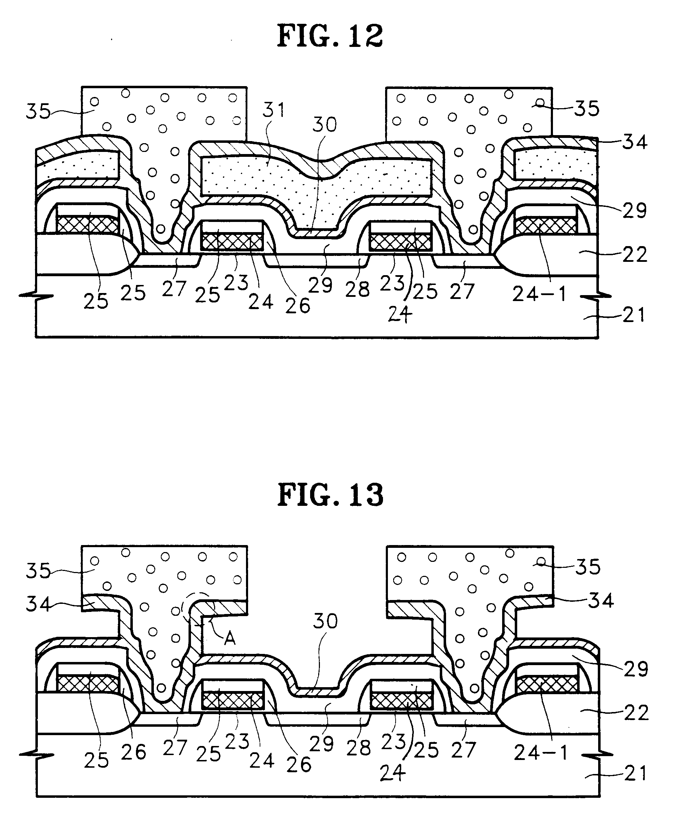

Figure 12 is a sectional view showing a step of forming the second conductive layer 34 on BPSG film 31 including the contact hole 33 and forming a photoresist pattern 35, so as to form a storage electrode. More particularly, polysilicon is deposited over the entire substrate wherein buried contact hole 33 is formed, into which impurities are then doped using arsenic ion-implantation or POCl₃, in order to form the second conductive layer 34 for the formation of the storage electrode. Second conductive layer 34 is formed to a thickness of approximately 1,000Å∼3,000Å. Meanwhile, a doped polysilicon layer as it is can be used as a material of the second conductive layer 34. Then, photoresist is coated and photoresist pattern 35 is formed by performing a photolithography process wherein a mask for storage electrode formation is applied. Here, a conventional mask for forming the storage electrode of an STC cell can be used.

Figure 13 is a sectional view showing a step of etching second conductive layer 34 and BPSG film 31 using photoresist pattern 35 as an etching mask. At first. second conductive layer 34 exposed by photoresist pattern 35 is etched. At this time, since the BPSG film 31 under second conductive layer 34 existed to a sufficient thickness, it is no problem to over-etch the second conductive layer 34. Accordingly, the risk of generating stringers in the peripheral circuitry is removed. Then, the remaining BPSG film 31 is wet etched using HF or buffered oxide etchant (BOE) solution. At this time, the process is simplified and the BPSG film is completely removed because the wet-etching is used instead of the conventional dry etching. The lower and side surfaces of the second conductive layer 34 exposed by the wet processing can be used as an effective area of storage electrode.

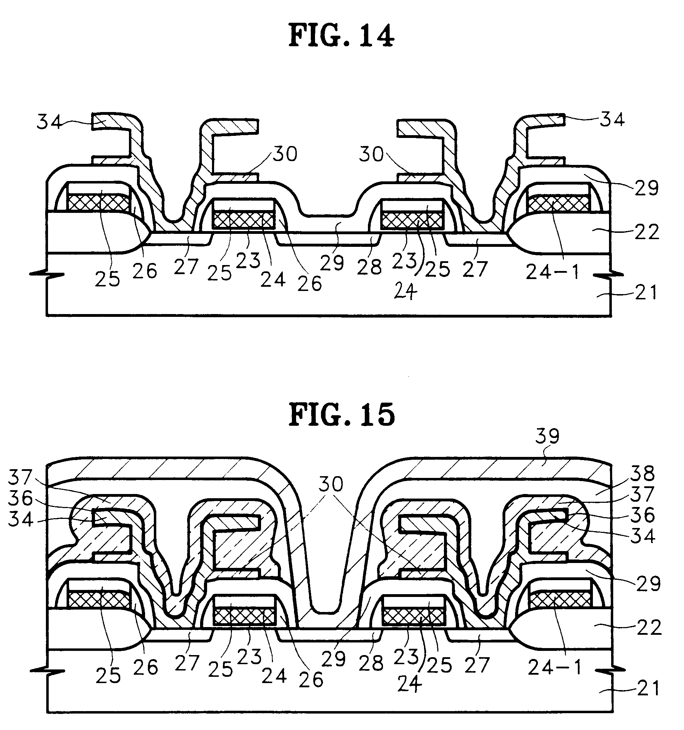

Figure 14 is a sectional view showing a step of forming the storage electrode of the capacitor. More particularly, the remaining photoresist pattern 35 is baked and hardened for good adhesion of the photoresist. And then, a double fin-structured storage electrode consisting of first and second conductive layers 30 and 34 is formed by etching first conductive layer 30 using photoresist pattern 35 as an etching mask.

Figure 15 is a sectional view showing a step of completing the capacitor and forming bit-line 39. That is, as a dielectric film 36, for example, oxide/nitride/oxide (ONO) film is formed over the exposed surface of the storage electrode, and a third conductive layer is formed over the whole surface of the resultant as to form a plate electrode 37, and then insulating film 38 for insulating the bit-line (formed later) and plate electrode 37 are formed. Then, a contact hole is formed on drain region 28, and a fourth conductive layer is formed on the whole surface of the resultant so as to form a bit-line 39, thereby to complete the manufacturing process of the capacitor.

According to the manufacturing method of a semiconductor memory device disclosed in Embodiment 1 shown in Figure 6 to 15, the photolithography process difficulties which are caused by the severe step difference and result in problems with the process of forming the conventional fin-structured capacitor of Ema et al.. can be solved by planarization using the BPSG film. Also, the conventional complicated process of dry-etching wherein the processing condition is changed by alternating the conductive layer and insulating layer when the etching process is performed so as to form a storage electrode can be simplified through the wet-etching process of this embodiment of the invention for removing the BPSG. Furthermore, Embodiment 1 also removes the risks of stringer generation.

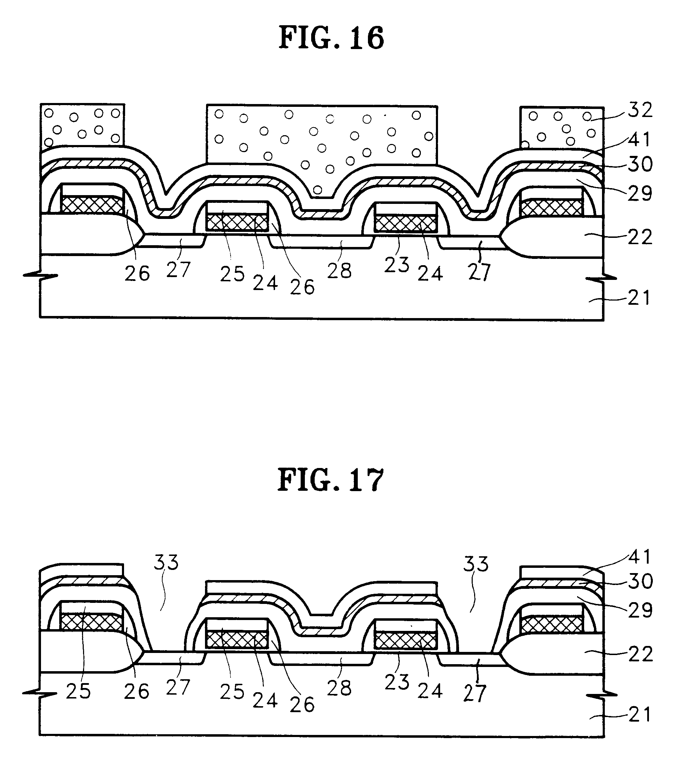

Figures 16 to 21 are sectional views showing the manufacturing process of a semiconductor memory device according to the steps of Embodiment 2 of the present invention. Here, the first portion of the manufacturing process is entirely the same as that shown in Figures 6 to 9 of Embodiment 1, and the same reference numerals represent the same constitutional elements.

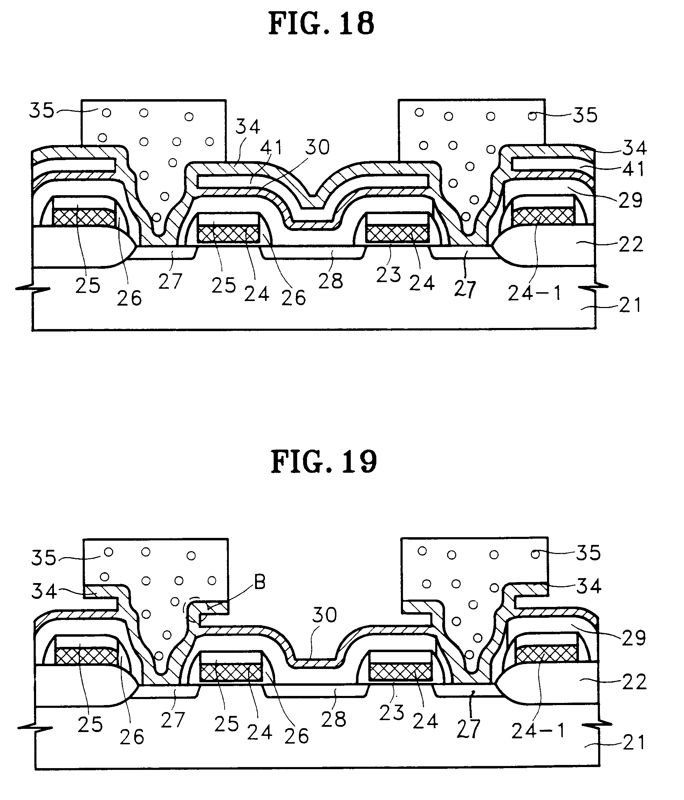

Figure 16 is a sectional view showing a step of forming a second material layer 41 on a first conductive layer 30, and forming a photoresist pattern 32, so as to form a contact hole following the steps of Figure 9. More particularly, a second material layer 41 is formed on first conductive layer 30, and a photoresist layer is formed on the whole surface of first conductive layer 30. Then, a photoresist pattern 32 is formed in order to form a buried contact hole. Second material layer 41 comprised of a material having a greater etching rate than that of first conductive layer 30 and the successive second conductive layer (reference numeral 34 of Figure 18), is formed on first conductive layer 30 to a uniform thickness. Second material layer 41 is formed as thin as possible, using HTO.

Meanwhile, a photoresist pattern 32 is formed to have the buried contact hole formed on source region 27, wherein photoresist pattern 32 is formed by use of a mask having an expanded exposure area larger than that of a buried contact mask of the conventional STC cell or a mask of the conventional STC cell as in Embodiment 1. Even if the buried contact mask whose exposing area is expanded is used, when the succeeding buried contact hole is formed using the photoresist pattern 32 formed by the above mask as an etching mask, the first conductive layer 30 operates as an etching block film thereby to narrow the width of the buried contact hole since the part of first conductive layer 30 is protruded toward the inside of the buried contact hole and remains. This enables the buried contact hole to be formed satisfactorily small, and assures a sufficient process margin. The width of the buried contact hole can be controlled in accordance with the remainder of the first conductive layer which protrudes toward the inside of the buried contact when the buried contact is etched, by controlling the thickness of first conductive layer 30 and etching time.

Figure 17 is a sectional view showing the step of forming the contact hole 33. More particularly, the buried contact hole 33 is formed so as to expose source region 27, wherein the exposed second material layer 41 is etched using photoresist pattern 32 of Figure 16 as an etching mask. A polymeric material is generated around the HTO film when second material layer 41, i.e. the HTO film, is etched, and the amount of generated polymeric material can be controlled depending on the etching time. This polymeric material also operates as an etching block film, which gives an advantage in reducing the width of the buried contact hole. Meanwhile, first material layer 30 below the second material layer 41 is not greatly attacked during the buried contact hole etching since the second material layer 41 is very thin, for example 1,000Å or less, as compared with the BPSG film, i.e. the first material layer 31 shown in Embodiment 1.

However, as shown in Figure 10, BPSG film 31 in Embodiment 1 is planarized with a thick layer formed on the source region 27 of transistor in which the buried contact hole is to be formed. Therefore, BPSG film 31 a buried contact hole 33 has to be completely removed during the etching process for forming buried contact hole 33, which needs an over-etching. Accordingly, first conductive layer 30 below the BPSG film 31 is attacked. Thus, HTO films 29, 26 and 25 below the first conductive layer are also attacked when the first conductive layer in the state of attacked is etched. Further, semiconductor substrate 21 below HTO film 29 within buried contact hole 33 may be damaged, and gate electrode 24 may be attacked to cause a short between the successive second conductive layer 34 and gate electrode 24.

Then, buried contact hole 33 is formed by etching first conductive layer 30 and third HTO film 29 below first conductive layer 30. Buried contact hole 33 becomes narrower towards its bottom due to the operations of the above polymer and the protruded first conductive layer 30, as shown in Figure 11 of Embodiment 1. Accordingly, the spacing between buried contact hole 33 and the gate electrode 24 is assured sufficiently, thereby to prevent shorts and improve insulation characteristics.

Figure 18 is a sectional view showing a step of forming a second conductive layer 34 on second material layer 41 having the above contact hole 33 and a photoresist pattern 35 for the formation of the storage electrode of the capacitor. More particularly, the second conductive layer 34 is formed on the whole surface of the resultant structure wherein contact hole 33 is formed, and a photoresist is also coated thereon. Then, photoresist pattern 35 is formed so as to form a storage electrode of the capacitor. Second conductive layer 34 is formed by using polysilicon, for example, the material used for first conductive layer 30. Here, it is preferable to form the second conductive layer 34 to be sufficiently thin, for example, 1,000Å or less. If the second conductive layer 34 is formed thickly, the buried contact hole 33 may be filled thereby to largely reduce the effective area of the storage electrode or generate a void in the lower part of the buried contact hole.

Figure 19 is a sectional view showing a step of etching a part of second conductive layer 34 using photoresist pattern 35 as an etching mask, and removing second material layer 41 below second conductive layer 34. More particularly, only second conductive layer 34 is dry-etched using photoresist pattern 35 of Figure 18 as an etching mask, and then all of the exposed second material layer 41 is removed by wet-etching. Here, HF or a super buffered oxide etchant (SBOE) solution can be used as a chemical etchant. The etching rate of HTO film as the second material layer 41 is very great as compared with that of the BPSG film of Embodiment 1. For example, when the BOE solution is used as an etching solution, the etching rate of BPSG film is 800-900Å per minute while the etching rate of HTO film is 1,800-2,000Å per minute, which shows that the etching rate of the HTO film is about twice that of BPSG film.

Since the BPSG film 31 of Embodiment 1 is formed very thick so as to planarize its surface, the etching time becomes much longer. Therefore, the weak part "A" of the second conductive layer 34 as shown in Figure 13 is attacked during an etching process, which causes a concern in that the weak part may be broken.

However, second material layer 41 is formed very thin and has a very great etching rate. Therefore, part "B" of Figure 19, i.e. the weak part of the fin-structured storage electrode, is only barely attacked.

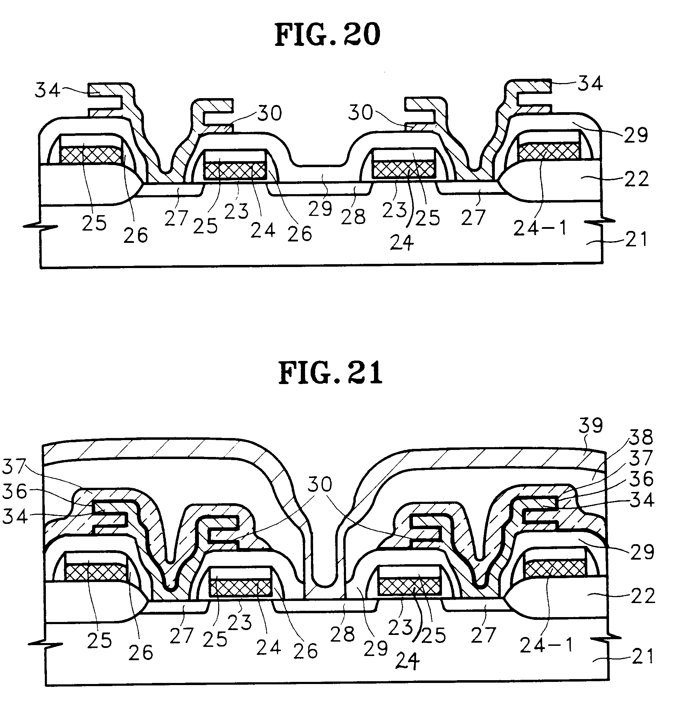

Figure 20 is a sectional view showing a step of completing the storage electrode of the capacitor. In detail, photoresist pattern 35 of Figure 19 is baked and hardened to obtain good adhesion, and is then used as a mask for etching the exposed first conductive layer 30. Then, the storage electrode consisting of first and second conductive layers 30 and 34 is completed.

Figure 21 is a sectional view showing the capacitor completed and the bit-line 39 formed. More particularly, an oxide/nitride/oxide (ONO) film is formed on the whole surface of the storage electrode as a dielectric film 36, and the plate electrode 37 is formed by forming a third conductive layer on the whole surface of the resultant structure. Then, insulating film 38 for insulating the bit-line (formed later) and plate electrode 37 are formed, and then a contact hole is formed on drain region 28. Thereafter, a fourth conductive layer is formed on the whole surface of the semiconductor substrate, and then bit line 39 is formed.

As can be seen from Embodiment 2 of the present invention, forming a thin HTO film between the first and second conductive layers in manufacturing the double fin-structured capacitor can prevent a second conductive layer from damage caused by over-etching, and the successive back-end processing can be performed smoothly due to the good topography of the cells. Further, the formed transistor does not change its characteristic because a reflow processing for planarizing the surface of a BPSG layer, as in Embodiment 1, does not need to be performed at high temperature. Also, the width of the buried contact hole can be adequately decreased and a sufficient process margin can be assured.

It should be understood that, although preferred embodiments of the present invention have been described in detail above, many modifications and variations could be effected therein by one with ordinary skill in the art without departing from the spirit and scope of the invention.

The reader's attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A method of manufacturing a semiconductor memory device comprising the steps of:
sequentially forming a first insulating layer and a first conductive layer (30) on a semiconductor substrate (21) on whose surface region is formed a transistor;
forming a planarized first material layer (31) which can be wet-etched, on said first conductive layer (30);
forming a contact hole (33) so as to expose said semiconductor substrate (21) in a predetermined region of said first material layer (31);
forming a second conductive layer (34) on said first material layer (31) including said contact hole (33);
forming a photoresist pattern (35) on said second conductive layer (34) which ranges from the centre of said contact hole (33) outwardly to a predetermined distance;
etching said second conductive layer (34) formed below said photoresist pattern (35) using said photoresist pattern (35) as an etching mask;
wet-etching said first material layer (31) below said second conductive layer (34); and
etching said first conductive layer (30) formed below said first material layer (31) using said photoresist pattern (35) as an etching mask thereby to form a storage electrode of a capacitor consisting of the remainder of said first and second conductive layers (30 and 34).

2. A method of manufacturing a semiconductor memory device according to claim 1, wherein a gate electrode (24) of said transistor is formed by forming a high temperature oxide film (25) on a gate electrode forming material, and patterning said gate electrode forming material and high temperature oxide film together.

3. A method of manufacturing a semiconductor memory device according to claim 2, wherein the thickness of said high temperature oxide film (25) is approximately 1,000Å or less.

4. A method of manufacturing a semiconductor memory device according to claim 1, 2 or 3, wherein said first conductive layer (30) is formed to a thickness of 500Å-3000Å using polysilicon.

5. A method of manufacturing a semiconductor memory device according to claim 1, 2, 3 or 4. wherein said first material layer (31) is formed by depositing BPSG which then is flowed.

6. A method of manufacturing a semiconductor memory device according to any of the preceding claims, wherein said first material layer (31) is wet-etched using HF or a BOE solution.

7. A method of manufacturing a semiconductor memory device according to any of the preceding claims, wherein a lower part of the contact hole (33) is formed narrower than an upper part by performing a self-alignment process by means of said first conductive layer (30).

8. A method of manufacturing a semiconductor memory device according to any of the preceding claims, wherein the width of said contact hole (33) is controlled by adjusting the thickness of said first conductive layer (30) and the etching time.

9. A method of manufacturing a semiconductor memory device according to any of the preceding claims, further comprising the step of baking said photoresist pattern (35) after said first material layer (31) is wet-etched away.

10. A method of manufacturing a semiconductor memory device according to any of the preceding claims, further comprising the steps of removing the photoresist pattern (35) which remains on said second conductive layer (34) after forming said storage electrode of a capacitor; and forming a dielectric film (36) and a plate electrode (37) of the capacitor.

11. A method of manufacturing a semiconductor memory device comprising the steps of:
sequentially forming a first insulating layer and a first conductive layer (30) on a semiconductor substrate (21) on whose surface region is formed a transistor;
forming a second material layer (41) having an etching rate greater than those of said first conductive layer (30) and a subsequent second conductive layer (34) to a substantially uniform thickness, on said first conductive layer (30);
forming a contact hole (33) so as to expose said semiconductor substrate (21) in a predetermined region of said second material layer (41);
forming said second conductive layer (34) on said second material layer (41) including said contact hole (33);
forming a photoresist pattern (35) which ranges from the centre of said contact hole (33) outwardly to a predetermined distance;
etching said second conductive layer (34) formed below said photoresist pattern (35) using said photoresist pattern (35) as an etching mask;
wet-etching the second material layer (41) below said second conductive layer (34); and
etching said first conductive layer (30) formed below said second material layer (41) using said photoresist pattern (35) as an etching mask thereby to form a storage electrode of a capacitor consisting of the remainder of said first and second conductive layers (30 and 34).

12. A method of manufacturing a semiconductor memory device according to claim 11, wherein said second material layer (41) is a high temperature oxide (HTO) film.

13. A method of manufacturing a semiconductor memory device according to claim 12, wherein the width of the contact hole (35) is controlled by adjusting an amount of polymeric material generated when said HTO film is etched in forming the contact hole (33).

14. A method of manufacturing a semiconductor memory device according to claim 11, 12 or 13, wherein said second conductive layer (34) is formed such that the inside of said contact hole (33) is not filled.

15. A method of manufacturing a semiconductor memory device according to claim 11, 12, 13 or 14, wherein said second material layer (41) is wet-etched using HF or a BOE solution.

16. A method of manufacturing a semiconductor memory device according to claim 11, 12, 13, 14 or 15, wherein the width of said contact hole (33) is controlled by adjusting the thickness of said first conductive layer (30).

17. A method of forming a capacitor of fin-structure as part of a semiconductor memory device, including the steps of forming first and second conductive layers which are spaced by a material that can be wet-etched, and subsequently wet-etching said material to remove it from between said first and second conductive layers.

18. A method according to claim 17, further comprising any one or more of the features disclosed in the accompanying specification, claims, abstract and/or drawings, in any combination.

19. A semiconductor memory device that has been manufactured by a method according to any of the preceding claims.
